# EUROPÄISCHE PATENTSCHRIFT

(11) **EP 1 363 404 B1**
(45) Veröffentlichungstag und Bekanntmachung des Hinweises auf die Patenterteilung: **09.04.2014**
(21) Anmeldenummer: 03010032.5
(22) Anmeldetag: 02.05.2003
(51) Int. Cl.: H03M 5/08, G11B 20/10, H03M 5/18

(54) **Pulsweitenmoduliertes Sensorausgangssignal**
Pulse-width modulated sensor output signal
Signal de sortie d'un détecteur à modulation d'impulsions en largeur

(30) Priorität: 08.05.2002 DE 10220844
(43) Veröffentlichungstag der Anmeldung: 19.11.2003
(73) Patentinhaber: Micronas GmbH, 79108 Freiburg i. Br. (DE)
(72) Erfinder: Blossfeld, Lothar, Dipl.-Phys., 79874 Breitnau (DE)
(74) Vertreter: Koch Müller Patentanwaltsgesellschaft mbH

(56) Entgegenhaltungen:
- DE-A- 19 734 248
- DE-A- 19 737 999
- GB-A- 2 332 835
- HIORNS R E ET AL: "POWER DIGITAL TO ANALOGUE WIDT MODULATION AND DIGITAL SIGNAL PROCESSING" IEE PROCEEDINGS G. ELECTRONIC CIRCUITS & SYSTEMS, INSTITUTION OF ELECTRICAL ENGINEERS. STEVENAGE, GB, Bd. 140, Nr. 5, 1. Oktober 1993 (1993-10-01), Seiten 329-338, XP000400068 ISSN: 0622-0039

## Beschreibung

Die Erfindung betrifft ein Sensorausgangssignal, das in kodierter Form den binären Zustand oder den analogen Wert eines Meßsignals enthält. Die Kodierung und Übertragung erfolgt mittels eines pulsweitenmodulierten Rechtsecksignals, mit dem sowohl analoge als auch digitale Signale übertragen werden können. Pulsweitenmodulierte Signale sind vorteilhaft, weil ihre Auswertung auf der Empfängerseite einfach ist. In der Regel ist dort ein Prozessor vorhanden, der an einem Eingang das pulsweitenmodulierte Signal empfängt. Mittels einer Schaltschwelle in der Eingangsstufe wird zwischen einem ersten und zweiten logischen Zustand des Signals unterschieden und bestimmt, wie groß ihre zeitlichen Anteile innerhalb einer Signalperiode sind. Als zeitliche Referenz dient der Systemtakt im Prozessor, dessen Frequenz in der Regel wesentlich höher ist als die Frequenz der pulsweitenmodulierten Signale. Wenn der Systemtakt auch den Sensor steuert, dann ist eine direkte Verkopplung zwischen der relativ langen Periodendauer des pulsweitenmodulierten Signals und dem relativ hohen Systemtakt vorhanden. Auf der Sensorseite erfolgt die Umwandlung des Meßsignals mittels eines üblichen Pulsweitenmodulators, dessen Ausgang einen elektronischen Schalter steuert, der als eine Einfach- oder wie in der CMOS-Technik als eine Gegentaktschaltstufe ausgebildet ist. Pulsweitenmodulierte Signale definieren ferner durch ihre Periode die jeweilige Zeitbasis für die Übertragung. Jede Periode enthält mindestens einen Signalwechsel mit an- und absteigender Signalflanke. Fehlen diese Signalwechsel über einen längeren Zeitbereich, dann signalisiert das entweder eine Unterbrechung der Signal- oder Versorgungsleitungen oder einen Defekt im Sensor.

Sensoren mit pulsweitenmodulierten Ausgangssignalen sind beispielsweise in Kraftfahrzeugen zur Überwachung vielfältigster Zustände zu finden. Im einfachsten Fall ist dies die Erfassung von Ein- und Auszuständen oder im mehr analogen Fall die Erfassung von Positonen, z.B. die digitale Überwachung von Türen, Gurtschaltern usw. oder die analoge Erfassung von Tankfüllung, Klappenstellungen oder Kurbelwellenwinkel. Nachteile bei dieser Pulsweitenmodulation stellen Phasenfehler dar, die durch die endlichen Flankensteilheiten der Signale in Verbindung mit der Schaltschwelle im Empfänger entstehen. Die Leitungen zur Übertragung der Sensorsignale sind wegen ihrer Länge in der Regel stark kapazitiv belastet. Dies bietet einerseits Schutz gegenüber äußeren Störeinstrahlungen und andererseits werden auch eigene Abstrahlungen verhindert. Die kapazitive Belastung in Verbindung mit dem ohmschen und induktiven Leitungswiderstand verformt die Schaltflanken und verflacht diese insbesondere. Liegen die Schaltschwellen im Prozessor dann nicht exakt in der Signalmitte, können Phasenfehler entstehen, die ein falsches Pulsweitenmodulationverhältnis vortäuschen.

Die Aufgabe der Erfindung ist die Angabe eines pulsweitenmodulierten Sensorausgangssignals, das möglichst unempfindlich gegen Phasenfehler auf der Empfängerseite ist.

Die Lösung der Aufgabe besteht nach den kennzeichnenden Merkmalen der Erfindung darin, ein pulsweitenmodulierten Sensorausgangssignal mindestens einmal während eines Meßablaufs mit einer invertierten Kodierung nochmals abzugeben, wobei ein ursprünglich mit einem ersten logischen Zustand verknüpfter erster Signalteil mit einem logisch invertierten Zustand, dem zweiten Zustand, abgegeben wird und ein ursprünglich mit dem zweiten logischen Zustand verknüpfter zweiter Signalteil mit dem ersten logischen Zustand.

Durch die Invertierung der logischen Zustände bei der Abgabe des Sensorsignals läßt sich der Phasenfehler kompensieren, indem die gemessenen Zeitwerte des ersten oder zweiten Signalteils addiert werden. Dieser fehlerfreie Zeitwert wird nun in Beziehung zur Periodendauer gebracht. Die Periodendauer selbst bleibt unabhängig von der Lage der Schaltschwelle konstant. Durch die Invertierung wirkt sich der Phasenfehler einmal positiv und einmal negativ auf den jeweiligen Signalteil aus und fällt daher bei der Addition heraus.

Eine zweite Möglichkeit den Phasenfehler zu eliminieren ergibt sich ebenfalls durch die aufeinanderfolgende Übertragung der beiden zueinander invertierten Sensorausgangssignale. Werden auf der Empfängerseite die Zeitwerte der beiden ersten oder zweiten Signalteile subtrahiert, dann liefert das Messergebnis den zu berücksichtigenden Phasenfehler nach Vorzeichen und Größe. Dieser Phasenfehler wird empfängerseitig gespeichert und ermöglicht während der folgenden Übertragung Meßabfragen die Korrektur der falsch ausgewerteten Signale. Dieses Verfahren hat den Vorteil, daß die Invertierung nur einmal zu Beginn des jeweiligen Meßablaufs erfolgt und die weiteren Meßsignale in üblicher Form jeweils nur einmal als pulsweitenmodulierte Signale übertragen werden. Das beschleunigt die Übertragung und Auswertung. Für die Bestimmung des Phasenfehlers kann entweder das erste Meßsignal genommen werden oder ein für diesen Zweck vorgesehenes Testsignal mit vorgegebenem Modulationsverhältnis.

Damit auf der Empfängerseite leicht erkannt werden kann, wann ein neuer Meßwert oder der invertierte Meßwert übertragen wird, lassen sich in das Sensorausgangssignal Trennsignale einfügen. Derartige Trennsignale unterscheiden sich von den üblichen Meßsignalen dadurch, daß das Pulsweitenverhältnis Werte annimmt, die außerhalb des Bereiches für normale Meßwerte liegen.

Oder die Trennsignale weisen auf die Periode bezogen eine vergrößerte oder verkleinerte Anzahl von Signalwechseln aus.

Ob der Meßwert für die Invertierung gespeichert oder nochmals bestimmt wird, hängt allein von der Änderungsgeschwindigkeit der Meßsignale ab. Bei der Speicherung des Meßwertes hat man den zusätzlichen Vorteil, daß mindestens während der gesamten Dauer der invertierten Übertragung der Sensor Zeit hat, andere Aktionen durchzuführen, beispielsweise ein Systemtest oder eine Systemdiagnose oder er schaltett sich für diese Zeit ab. Dies kann sowohl sensorspezifische als auch externe Funktionen betreffen. Magnetsensoren sind dafür ein Beispiel. So ist es in Sicherheitssysteme wichtig zu erkennen, ob das Gesamtsystem aus Magnetsensor und Empfänger voll funktionsfähig oder defekt ist. Hierbei einbezogen ist selbstverständlich auch die Überprüfung der Versorgungs- und Signalleitungen.

Die Abfrage der Sensoren kann kontinuierlich sein oder sie kann innerhalb eines Abfragefensters stattfinden. Ein Abfragefenster bedeutet eine Aktivierung des Sensors durch ein Aktivierungssignal oder einfach durch die Zuführung der Versorgungsspannungen, worauf der Sensor das Meßsignal an die Empfängereinrichtung sendet. Da bei dieser streng vorgegebenen Betriebsweise die Reihenfolge von invertiertem und nichtinvertiertem Signal vorgebbar ist, ist eine spezielle Kennzeichnung durch Trennungssignale nicht erforderlich.

Bei einem kontinuierlichen Betrieb können die Signale empfängerseitig nicht mehr so ohne weiteres von einander unterschieden werden. In diesem Fall dienen die bereits erwähnten Trennsignale dazu, eine eindeutige Zuordnung vorzunehmen. Diese spezielle Kennzeichnung kann andererseits entfallen, wenn aus dem pulsweitenmodulierten Signal eindeutig erkennbar ist, ob es sich um das invertierte oder nichtinvertierte Signal handelt. Diese Kennung erfolgt beispielsweise dadurch, daß für das nichtinvertierte und invertierte Signal nichtüberlappende Zeitbereiche bei der Pulsweitenmodulation zur Verfügung stehen.

Ein weiterer Vorteil bei der Übertragung mit nichtinvertierten und invertierten Signalen ist die Gleichstromfreiheit, die gegebenenfalls sogar eine kapazitive Trennung der Signalleitung ermöglicht.

Die Erfindung und vorteilhafte Weiterbildungen werden nun anhand der Figuren der Zeichnung näher erläutert:
Fig. 1 zeigt schematisch im Zeitdiagramm den Auswertefehler bei einem pulsweitenmodulierten Signal mit flachen Schaltflanken bei einer nicht mittig liegenden Schaltschwelle im Empfänger,
Fig. 2 zeigt ein erstes Ausführungsbeispiel für ein pulsweitenmoduliertes Signal nach der Erfindung,
Fig. 3 zeigt ein pulsweitenmoduliertes Signal nach der Erfindung mit Trennsignal und
Fig. 4. zeigt ein weiteres pulsweitenmoduliertes Signal zur Phasenfehlererkennung.

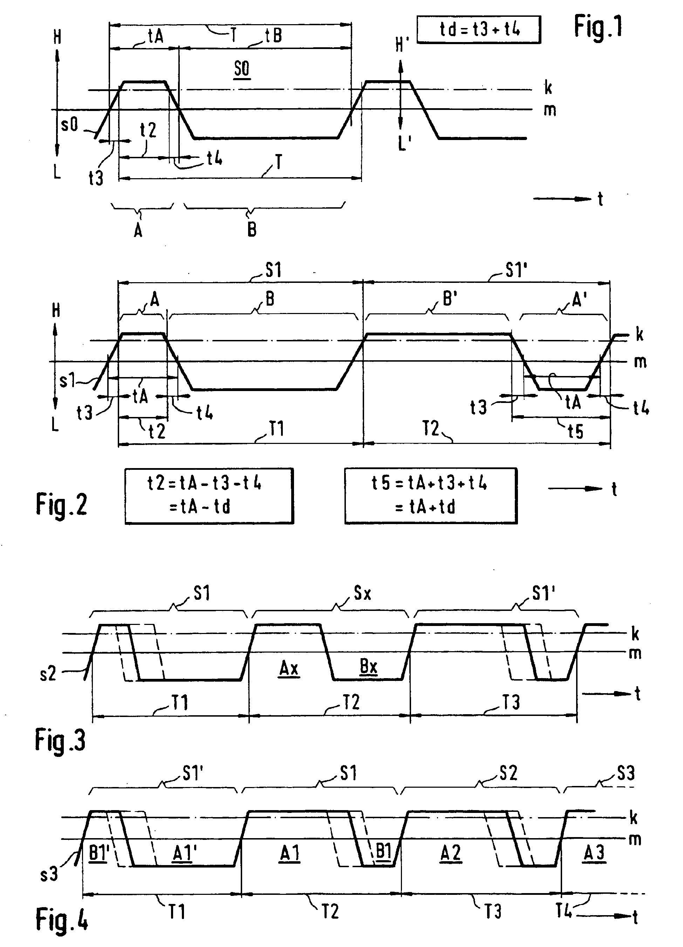

In Fig. 1 ist schematisch im Zeitdiagramm ein pulsweitenmoduliertes Signal s0 mit relativ flachen Signalflanken dargestellt. Die Schnittpunkte der Signalflanken mit einem mittleren Signalpegel m, die senderseitig die logischen Signalzustande H, L definieren, bilden einen ersten und zweiten Signalteil A, B eines Einzelsignals SO. Der erste Signalteil A entspricht dem Zeitintervall tA und der zweite Signalteil B dem Zeitintervall tB. Beide Zeitintervalle tA, tB, ergeben als Summe die Periodendauer T des Einzelsignals S0, die natürlich identisch mit der des gesamten Signals s0 ist: T = tA + tB. Auf der Empfängerseite definiert eine Schaltschwelle k, welche Teile des empfangenen Signals s0 einem ersten oder zweiten logischen Zustand H', L' zuzurechnen sind. Befindet sich diese Schaltschwelle k nicht mehr auf dem mittleren Signalpegel m, dann stimmen sender- und empfängerseitig die logischen Pegel H, L bzw. H', L' nicht mehr überein und durch die endliche Steilheit der Signalflanken tritt eine Verfälschung der Zeitintervalle für Signalteile A, B im Empfänger auf. Anstatt der richtigen Zeit tA wird jetzt für den ersten Signalteil A nur noch die Zeit t2 gemessen, die um die Zeitabschnitte t3, t4 kürzer als das Intervall tA ist. Entsprechend vergrößert sich das Intervall tB des zweiten Signalteils B um die Intervalle t3, t4. Zur Bestimmung des Pulsweitenverhältnisses auf der Empfängerseite wird zweckmäßigerweise nur eines der beiden Signalteile A, B und die Periodendauer T verwendet, da letztere durch die Lage der Schaltschwelle k nicht beeinflußt wird. Die Summe der Intervalle t3, t4 ergibt den Phasenfehler td.

In Fig. 2 wird im Zeitdiagramm ein erstes Ausführungsbeispiel der Erfindung anhand des pulsweitenmodulierten Signals s1 dargestellt. Dem Einzelsignal SO von Fig. 1 entspricht das Einzelsignal S1, das während einer ersten Periode T1 nichtinvertiert und während einer zweiten Periode T2 invertiert als Einzelsignal S1' übertragen wird. Der erste Signalteil A beim Signal S 1 ist dabei um die Intervalle t3, t4 kleiner als das richtige Intervall tA. Bei der invertierten Übertragung ist das Zeitintervall t5 für den ersten Signalteil A' um die Intervalle t3, t4 größer als das richtige Intervall tA. Wenn die fehlerbehafteten Intervalle t2, t5 für die ersten Signalteile A, A' addiert werden, dann haben die zugehörigen Phasenfehler td unterschiedliche Vorzeichen und kompensieren sich. Falls zur Bestimmung des Pulsweitenverhältnisses der zweite Signalteil B verwendet wird, werden die fehlerbehafteten Intervalle zweiten Signalteile B, B' addiert und damit der Phasenfehler td kompensiert.

Die Reihenfolge des ersten und zweiten Signalteils A, B ist in Fig. 2 in den beiden Perioden T1, T2 gegeneinander vertauscht. Auf diese Weise paßt das nichtinvertierte und das invertierte Signal flankenmäßig zusammen, siehe die ansteigende Signalflanke zwischen den Signalteilen B, B'.

In Fig. 3 sind im Zeitdiagramm als weiteres Ausführungsbeispiel der Erfindung drei aufeinanderfolgende Taktperioden eines pulsweitenmodulierten Signals s2 dargestellt. Während der ersten Taktperiode T1 wird wie in Fig. 2 ein erstes Einzelsignal S1 übertragen. In der zweiten Periode T2 wird ein zweites Einzelsignal Sx übertragen, das ein Pulsweitenverhältnis von etwas 0,5 hat. Dessen erster und zweiter Signalteil Ax, Bx sind etwa gleich lang. Wenn dieses Verhältnis mit realen Meßwerten nicht auftritt, dann kann dieses Pulsweitenverhältnis als ein Trennsignal dienen. Der Empfänger weiß dann, daß nach dem Trennsignal Sx wieder das erste Einzelsignal S1 kommt, aber in invertierter Form S1'. Danach wird ein neues Einzelsignal erwartet, dem ein Trennsignal Sx folgt und dann die Invertierung des zuvor empfangenen Einzelsignals. Die Reihenfolge der eintreffenden Einzelsignale ist so eindeutig definiert. Selbstverständlich können die Trennsignale auch an anderer Stelle im Signalverlauf s2 eingefügt sein, so daß beispielsweise eine Trennung nach zusammengehörigen Einzelsignalen erfolgt und die Signalpaare nicht getrennt werden.

In Fig. 4 ist ein pulsweitenmoduliertes Signal s3 im Zeitdiagramm dargestellt, das der Ermittlung des Phasenfehlers td dient. Hierzu wird in der ersten Periode T1 ein invertiertes Einzelsignal S1' mit den Signalteilen B1' und A1' übertragen und danach das dazugehörige nichtinvertierte Einzelsignal S 1 mit den Signalteilen A1,B1. Aus diesem Signalpaar S1', S1 wird im Empfänger der Phasenfehler td bestimmt, der dann bei der Erfassung der weiteren Einzelsignale S2, S3 in den Perioden T3, T4 zur Korrektur der Zeitintervalle der ersten Signalteile A2, A3 dient.

## Patentansprüche

1. Sensorausgangssignal, das mittels eines pulsweitenmodulierten Signals (s1; s2; s3) den momentanen Wert eines Meßsignals in kodierter Form enthält, wobei der momentane Wert einem zeitlichen Verhältnis aus einem ersten und zweiten Signalteil (A, B) entspricht, die sich durch einen ersten bzw. einen zweiten logischen Zustand (H, L) voneinander unterscheiden,
**dadurch gekennzeichnet, dass** mindestens einmal während eines Meßablaufs ein bereits als nichtinvertiertes Einzelsignal (S1) abgegebener Meßwert mit einer invertierten Kodierung nochmals als ein invertiertes Einzelsignal (S1') abgebeben wird, wobei der erste Signalteil (A) mit dem zweiten logischen Zustand (L) und der zweite Signalteil (B) mit dem ersten logischen Zustand (H) verknüpft wird, derart, dass bei einer Addition von Zeitwerten der ersten Signalteile (A, A') oder der zweiten Signalteile (B, B') ein Phasenfehler kompensiert wird.

2. Sensorausgangssignal nach Anspruch 1, **dadurch gekennzeichnet, daß** das zeitliche Verhältnis auf einen konstanten Zeitwert (T) bezogen ist.

3. Sensorausgangssignal nach Anspruch 2, **dadurch gekennzeichnet, daß** der konstante Zeitwert mit einer Taktperiode (T) verknüpft ist.

4. Sensorausgangssignal nach Anspruch 3, **dadurch gekennzeichnet, daß** die Taktperiode (T) im pulsweitenmodulierten Signal (s1; s2; s3) enthalten ist.

5. Sensorausgangssignal nach Anspruch 1, **dadurch gekennzeichnet, daß** jeder Meßwert mindestens einmal als nichtinvertiertes Einzelsignal (S1) und mindestens einmal als invertiertes Einzelsignal (S1') abgegeben wird, wobei die Reihenfolge beliebig ist.

6. Sensorausgangssignal nach Anspruch 5, **dadurch gekennzeichnet, daß** bei den alternierend erzeugten nichtinvertierten und invertierten Einzelsignalen (S1, S1') die jeweilige Reihenfolge aus dem erstem und zweitem Signalteil (A, B bzw. B', A') vertauscht wird.

7. Sensorausgangssignal nach Anspruch 1, **dadurch gekennzeichnet, daß** zu Beginn des Meßablaufs ein Messwert oder ein fester Referenzwert in normaler und invertierter Kodierung als ein Einzelsignal (S1, S1') abgegeben wird, aus dem empfängerseitig ein Phasenfehler (td) bestimmt und gespeichert wird, der nachfolgenden Einzelsignalen (S2, S3) als Korrekturwert dient.

8. Sensorausgangssignal nach einem der Ansprüche 1 bis 7, **dadurch gekennzeichnet, daß** in dem Meßablauf mindestens ein erstes Trennsignal (Sx) vorhanden ist, das empfängerseitig eine einfache Unterscheidung zwischen nichtinvertierten und invertierten Einzelsignalen (S1, S1') ermöglicht.

9. Sensorausgangssignal nach einem der Ansprüche 1 bis 8, **dadurch gekennzeichnet, daß** in dem Meßablauf mindestens ein zweites Trennsignal vorhanden ist, mit dem während des Meßablaufs das Ende oder der Beginn eines neuen Einzelsignals signalisiert wird.

10. Sensorausgangssignal nach Anspruch 1, **dadurch gekennzeichnet, daß** während der Übertragung des invertierten Ausgangssignals im Sensor ein Systemtest erfolgt, dessen Ergebnis während des Meßablaufes mittels eines Einzelsignals (S1, S2, S3) übertragen wird.

11. Sensorausgangssignal nach einem der Ansprüche 1 bis 10, **dadurch gekennzeichnet, daß** der erste und zweite logische Zustand (H, L) durch unterschiedliche Strompegel definiert sind.

12. Sensorausgangssignal nach Anspruch 11, **dadurch gekennzeichnet, daß** die unterschiedlichen Strompegel an den Versorgungsanschlüssen eines Zweibeinelementes abgreifbar sind.

## Claims

1. Sensor output signal, which by means of a signal (s1; s2; s3) modulated in pulse width contains the instantaneous value of a measurement signal in coded form, wherein the instantaneous value corresponds with a time ratio of a first signal part (A) and second signal part (B), which differ from one another by a first logical state (H) or a second logical state (L), **characterised in that** a measurement value with an inverted coding already provided as a non-inverted individual signal (S1) is provided again as an inverted individual signal (S1') at least once during a measuring process, wherein the first signal part (A) is linked with the second logical state (L) and the second signal part (B) is linked with the first logical state (H) in such a manner that in the case of addition of time values of the first signal parts (A, A') or of the second signal parts (B, B') compensation for a phase error is provided.

2. Sensor output signal according to claim 1, **characterised in that** the time ratio is referred to a constant time value (T).

3. Sensor output signal according to claim 2, **characterised in that** the constant time value is linked with a clock period (T).

4. Sensor output signal according to claim 3, **characterised in that** the clock period (T) is included in the signal (s1; s2; s3) with pulse width modulation.

5. Sensor output signal according to claim 1, **characterised in that** each measurement value is provided at least once as a non-inverted individual signal (S1) and at least once as an inverted individual signal (S1') in any order.

6. Sensor output signal according to claim 5, **characterised in that** when the non-inverted and inverted individual signals (S1, S1') are produced in alternation the respective order of the first and second signal parts (A, B or B', A') is exchanged.

7. Sensor output signal according to claim 1, **characterised in that** at the beginning of the measuring process a measurement value or a fixed reference value in normal and inverted coding is provided as an individual signal (S1, S1'), from which at the receiver a phase error (td) is determined and stored and serves as a correction value for subsequent individual signals (S2, S3).

8. Sensor output signal according to any one of claims 1 to 7, **characterised in that** present in the measuring process is at least one first separation signal (Sx) which at the receiver enables simple distinction between non-inverted and inverted individual signals (S1, S1').

9. Sensor output signal according to any one of claims 1 to 8, **characterised in that** present in the measuring process is at least one second separation signal by which the end or the start of a new individual signal is signalled during the measuring process.

10. Sensor output signal according to claim 1, **characterised in that** during transmission of the inverted output signal a system test, the result of which is transmitted during the measuring process by means of an individual signal (S1, S2, S3), is carried out in the sensor.

11. Sensor output signal according to any one of claims 1 to 10, **characterised in that** the first and second logical states (H, L) are defined by different current levels.

12. Sensor output signal according to claim 11, **characterised in that** the different current levels can be derived at the supply terminals of a bipod element.

## Revendications

1. Signal de sortie d'un détecteur, qui contient sous forme codée la valeur instantanée d'un signal de mesure au moyen d'un signal (s1; s2; s3) à modulation de largeur d'impulsion, dans lequel la valeur instantanée correspond à un rapport temporaire entre une première et une deuxième parties de signal (A, B), qui se distinguent l'une de l'autre par un premier ou un deuxième état logique (H, L), **caractérisé en ce que**, au moins une fois pendant une opération de mesure, une valeur de mesure déjà émise comme signal individuel non inversé (S1) est encore une fois émise avec un codage inversé comme signal individuel inversé (S1'), dans lequel la première partie de signal (A) est liée avec le deuxième état logique (L) et la deuxième partie de signal (B) est liée avec le premier état logique (H), de telle manière qu'une erreur de phase soit compensée lors d'une addition de valeurs temporelles de la première partie de signal (A, A') ou de la deuxième partie de signal (B, B').

2. Signal de sortie de détecteur selon la revendication 1, **caractérisé en ce que** le rapport temporaire est rapporté à une valeur de temps constante (T).

3. Signal de sortie de détecteur selon la revendication 2, **caractérisé en ce que** la valeur de temps constante est liée à une période d'horloge (T).

4. Signal de sortie de détecteur selon la revendication 3, **caractérisé en ce que** la période d'horloge (T) est contenue dans le signal modulé en largeur d'impulsion (s1; s2; s3).

5. Signal de sortie de détecteur selon la revendication 1, **caractérisé en ce que** chaque valeur de mesure est émise au moins une fois comme signal individuel non inversé (S1) et au moins une fois comme signal individuel inversé (S1'), l'ordre étant quelconque.

6. Signal de sortie de détecteur selon la revendication 5, **caractérisé en ce qu'**avec les signaux individuels non inversés et inversés (S1, S1') produits en alternance, l'ordre respectif de la première et de la deuxième parties de signal (A, B ou B', A') est permuté.

7. Signal de sortie de détecteur selon la revendication 1, **caractérisé en ce qu'**au début de l'opération de mesure, une valeur de mesure ou une valeur de référence fixe est émise en codage normal et inversé comme signal individuel (S1, S1'), à partir duquel une erreur de phase (td) est déterminée du côté réception et mémorisée, qui sert de valeur de correction pour les signaux individuels suivants (S2,S3).

8. Signal de sortie de détecteur selon l'une quelconque des revendications 1 à 7, **caractérisé en ce que**, lors de l'opération de mesure, il se trouve au moins un premier signal de séparation (Sx), qui permet du côté réception une distinction simple entre des signaux individuels non inversés et inversés (S1, S1').

9. Signal de sortie de détecteur selon l'une quelconque des revendications 1 à 8, **caractérisé en ce que**, lors de l'opération de mesure, il se trouve au moins un deuxième signal de séparation, avec lequel on signale la fin ou le début d'un nouveau signal individuel pendant l'opération de mesure.

10. Signal de sortie de détecteur selon la revendication 1, **caractérisé en ce que**, pendant la transmission du signal de sortie inversé, il se produit dans le détecteur un test de système, dont le résultat est transmis pendant l'opération de mesure au moyen d'un signal individuel (S1, S2, S3).

11. Signal de sortie de détecteur selon l'une quelconque des revendications 1 à 10, **caractérisé en ce que** le premier et le deuxième états logiques (H, L) sont définis par des niveaux de courant différents.

12. Signal de sortie de détecteur selon la revendication 11, **caractérisé en ce que** les différents niveaux de courant peuvent être prélevés aux bornes d'alimentation d'un élément à deux branches.
